# EUROPÄISCHE PATENTSCHRIFT

(11) **EP 3 607 607 B1**
(45) Veröffentlichungstag und Bekanntmachung des Hinweises auf die Patenterteilung: **07.05.2025**
(21) Anmeldenummer: 18726057.5
(22) Anmeldetag: 22.03.2018
(51) Int. Cl.: G01R 31/396, H01M 10/48

(54) **ERFASSUNGSVORRICHTUNG, BATTERIESTAPEL SOWIE VERFAHREN ZUM MONTIEREN EINER ERFASSUNGSVORRICHTUNG**
DETECTION DEVICE, BATTERY STACK, AND METHOD FOR MOUNTING A DETECTION DEVICE
DISPOSITIF DE DÉTECTION, EMPILEMENT DE BATTERIES ET PROCÉDÉ DE MONTAGE D'UN DISPOSITIF DE DÉTECTION

(30) Priorität: 07.04.2017 DE 102017206038
(43) Veröffentlichungstag der Anmeldung: 12.02.2020
(73) Patentinhaber: Lion Smart GmbH, 85748 Garching (DE)
(72) Erfinder: QUINGER, Daniel, 82211 Herrsching (DE); MAYER, Tobias, 80805 München (DE); HEIN, Dominic, 80797 München (DE); ALLMENDINGER-HAGENMAIER, Mark, 82194 Gröbenzell (DE); BEHLEN, Christian, 83135 Schechen (DE)
(74) Vertreter: Bals & Vogel Patentanwälte PartGmbB
(86) Internationale Anmeldenummer: PCT/EP2018/057352
(87) Internationale Veröffentlichungsnummer: WO 2018/184863

(56) Entgegenhaltungen:
- EP-A1- 2 742 564
- EP-B1- 2 742 564
- DE-U1- 8 901 394
- DE-U1- 9 307 800
- US-A1- 2011 313 589
- US-A1- 2017 093 104

## Beschreibung

Die Erfindung betrifft eine Erfassungsvorrichtung zum Erfassen wenigstens einer Batterieeigenschaft zumindest einer Batteriezelle einer Batterieebene eines Batteriestapels, aufweisend einen Träger mit zumindest einem elektrischen Leitungselement und mindestens einem Kontaktelement mit einem Kontaktabschnitt zum Kontaktieren eines Gegenkontaktabschnitts der zumindest einen Batteriezelle, wobei das Kontaktelement einen Sensorabschnitt zum Erfassen der wenigstens einen Batterieeigenschaft der Batteriezelle aufweist und der Sensorabschnitt mit dem zumindest einen Leitungselement zum Weiterleiten der zumindest einen erfassten Batterieeigenschaft datenkommunizierend verbunden ist. Ferner betrifft die Erfindung einen Batteriestapel, aufweisend zumindest eine Batterieebene mit wenigstens einer Batteriezelle und eine Erfassungsvorrichtung. Darüber hinaus betrifft die Erfindung ein Verfahren zum Montieren einer Erfassungsvorrichtung an einem Batteriestapel mit zumindest einer Batterieebene mit wenigstens einer Batteriezelle, wobei die wenigstens eine Batteriezelle einen Gegenkontaktabschnitt aufweist.

Elektrische Energiespeicher werden in der modernen Technik weitläufig eingesetzt, beispielsweise in Elektrofahrzeugen. Mögliche Ausgestaltungsformen derartiger Energiespeicher sind beispielsweise Lithium-Ionen-Batterien. Um eine Leistungsfähigkeit derartiger Batterien zu steigern ist es zum Beispiel bekannt, mehrere einzelne Batteriezellen in einer Batterieebene elektrisch parallel zu verschalten. Um eine weitere Steigerung zu erzielen, können zwei oder mehrere dieser Batterieebenen zu einem Batteriestapel seriell verschaltet werden. Dazu können insbesondere die einzelnen Batterieebenen aufeinander angeordnet und elektrisch leitend verbunden werden.

Eine Überwachung eines Zustands eines derartigen Batteriestapels wird oftmals durchgeführt, um eine Sicherheit beim Betreiben des Batteriestapels zu gewährleisten. Es ist beispielsweise bekannt, eine Spannung je einer Batteriezelle einer Batterieebene durch eine entsprechende Sensorvorrichtung einer Erfassungsvorrichtung zu ermitteln. Eine derartige Erfassungsvorrichtung umfasst dabei zumeist einen Träger, der sich über die Batterieebenen erstreckt und der bevorzugt für jede der Batterieebenen ein Kontaktelement aufweist, an dem die jeweilige Sensorvorrichtung angeordnet ist. Da, wie oben bereits ausgeführt, die Batteriezellen einer Batterieebene zueinander elektrisch parallel geschaltet sind, kann bereits durch eine Messung einer Spannung einer einzelnen Batteriezelle einer Batterieebene eine Überwachung der gesamten Batterieebene bereitgestellt werden.

Gemäß dem Stand der Technik ist es bekannt, für jede Batterieebene das jeweilige Kontaktelement mit je einer Batteriezelle oder mit dem parallel verschaltenden Element jeder der Batterieebenen materialschlüssig zu verbinden. Insbesondere bei großen Batteriestapeln, die mehrere Batterieebenen, insbesondere mehr als zehn oder sogar mehr als 50 Batterieebenen, aufweisen, stellt dies einen großen Arbeits-, Zeit- und insbesondere Kostenaufwand bei der Herstellung des Batteriestapels dar. Dies ist insbesondere dadurch begründet, dass jede dieser Verbindungen einzeln angefertigt werden muss. Hohe Kosten bei der Anfertigung und Montage von Batteriestapeln sind die Folge.

Es ist Aufgabe der vorliegenden Erfindung, die voranstehend beschriebenen Nachteile zumindest teilweise zu beheben. Insbesondere ist Aufgabe der vorliegenden Erfindung, in kostengünstiger und einfacher Weise eine Erfassungsvorrichtung, einen Batteriestapel sowie ein Verfahren zur Montage einer Erfassungsvorrichtung bereitzustellen, durch die eine Bestückung eines Batteriestapels mit einer Erfassungsvorrichtung vereinfacht werden kann, wobei insbesondere eine Montage der Erfassungsvorrichtung am Batteriestapel vereinfacht und dadurch beschleunigt werden kann.

Voranstehende Aufgabe wird gelöst durch eine Erfassungsvorrichtung mit den Merkmalen des Anspruchs 1, durch einen Batteriestapel mit den Merkmalen des Anspruchs 14, sowie durch ein Verfahren zur Montage einer Erfassungsvorrichtung mit den Merkmalen des Anspruchs 15. Weitere Merkmale und Details der Erfindung ergeben sich aus den Unteransprüchen, der Beschreibung und den Zeichnungen. Dabei gelten Merkmale und Details, die im Zusammenhang mit der erfindungsgemäßen Erfassungsvorrichtung beschrieben sind, selbst verständig auch im Zusammenhang mit dem erfindungsgemäßen Batteriestapel sowie mit dem erfindungsgemäßen Verfahren und jeweils umgekehrt, so das bezüglich der Offenbarung zu den einzelnen Erfindungsaspekten stets wechselseitig Bezug genommen wird bzw. werden kann.

Gemäß einem ersten Aspekt der Erfindung wird die Aufgabe gelöst durch eine Erfassungsvorrichtung zum Erfassen wenigstens einer Batterieeigenschaft zumindest einer Batteriezelle einer Batterieebene eines Batteriestapels, aufweisend einen Träger mit zumindest einem elektrischen Leitungselement und mindestens einem Kontaktelement mit einem Kontaktabschnitt zum Kontaktieren eines Gegenkontaktabschnitts der zumindest einen Batteriezelle, wobei das Kontaktelement einen Sensorabschnitt zum Erfassen der wenigstens einen Batterieeigenschaft der Batteriezelle aufweist und der Sensorabschnitt mit dem zumindest einen Leitungselement zum Weiterleiten der zumindest einen erfassten Batterieeigenschaft datenkommunizierend verbunden ist. Eine erfindungsgemäße Erfassungsvorrichtung ist dadurch gekennzeichnet, dass das Kontaktelement zumindest abschnittsweise flexibel ausgebildet ist und ein Magnetelement zum magnetischen Fixieren des Kontaktabschnitts am Gegenkontaktabschnitt aufweist.

Eine erfindungsgemäße Erfassungsvorrichtung ist für einen Einsatz mit einem Batteriestapel vorgesehen. Ein derartiger Batteriestapel weist dabei zumindest eine Batterieebene auf, in der wenigstens eine Batteriezelle angeordnet ist. Zumeist weist ein derartiger Batteriestapel mehrere Batterieebenen auf, wobei in jeder der Batterieebenen eine Vielzahl von Batteriezellen angeordnet und bevorzugt elektrisch parallel geschaltet ist. Eine erfindungsgemäße Erfassungsvorrichtung weist insbesondere einen Träger auf, wobei der Träger zumindest ein elektrisches Leitungselement und mindestens ein Kontaktelement aufweist. Der Träger weist bevorzugt eine längliche Form auf, wobei eine Längserstreckung des Trägers bevorzugt einer Höhe zumindest einer der Batterieebenen zumindest im Wesentlichen entspricht. Besonders bevorzugt erstreckt sich der Träger über sämtliche Batterieebenen des Batteriestapels. Ein derartiger Träger kann beispielsweise im Wesentlichen durch eine Leiterplatte bzw. durch eine Platine gebildet sein. Das Kontaktelement des Trägers weist wiederum einen Kontaktabschnitt auf, der für ein Kontaktieren eines Gegenkontaktabschnitts der zumindest einen Batteriezelle der Batterieebene vorgesehen ist. In einer bevorzugten Ausgestaltungsform erstreckt sich das gesamte Kontaktelement bzw. der Kontaktabschnitt senkrecht oder zumindest im Wesentlichen senkrecht zur Längserstreckung des restlichen Trägerelements, die bevorzugt parallel zu einer Höhe der Batterieebene ist. Der Kontaktabschnitt des Kontaktelements ist insbesondere zum Kontaktieren eines Gegenkontaktabschnitts der zumindest einen Batteriezelle ausgebildet. Dies kann beispielsweise bedeuten, dass die geometrische Form des Kontaktabschnitts an eine geometrische Ausgestaltung des Gegenkontaktabschnitts angepasst ausgebildet ist. Ferner weist das Kontaktelement einen Sensorabschnitt auf, der für ein Erfassen der wenigstens einen Batterieeigenschaft der Batteriezelle vorgesehen ist. Eine derartige Batterieeigenschaft kann beispielsweise eine Spannung, eine Temperatur oder Ähnliches sein, wobei der jeweilige Sensorabschnitt speziell für das Erfassen der gewünschten Batterieeigenschaft abgestimmt ausgebildet ist. Der Träger der erfindungsgemäßen Erfassungsvorrichtung weist ferner ein Leitungselement auf, mit dem der Sensorabschnitt datenkommunizierend verbunden ist. Dies ermöglicht ein Weiterleiten der durch den Sensorabschnitt ermittelten Daten der erfassten Batterieeigenschaft entlang des Leitungselements. Bevorzugt kann sich das Leitungselement über die gesamte Längserstreckung des Trägers erstrecken, sodass eine Bereitstellung der erfassten Batterieeigenschaft an zumindest einem der Enden des Trägers ermöglicht werden kann. Dort kann beispielsweise eine weitere Weiterleitung der erfassten Daten der Batterieeigenschaft an eine externe Auswertungsvorrichtung vorgenommen werden.

Erfindungswesentlich ist bei einer erfindungsgemäßen Erfassungsvorrichtung vorgesehen, dass das Kontaktelement zumindest abschnittsweise flexibel ausgebildet ist. Abschnittsweise flexibel im Sinne der Erfindung bedeutet dabei insbesondere, dass das Kontaktelement in Bezug auf den restlichen Träger beweglich ausgebildet ist. Ein besonders gutes Anordnen des Kontaktabschnitts des Kontaktelements am Gegenkontaktabschnitt der Batteriezelle kann dadurch auf besonders einfache Art und Weise bereitgestellt werden. Unterstützt wird dies darüber hinaus dadurch, dass das Kontaktelement ein Magnetelement aufweist, das zum magnetischen Fixieren des Kontaktabschnitts am Gegenkontaktabschnitt vorgesehen ist. Bei der Montage einer erfindungsgemäßen Erfassungsvorrichtung kann dies dahingehend ausgenützt werden, dass beispielsweise der Kontaktabschnitt des Kontaktelements durch ein Ausrichten der gesamten Erfassungsvorrichtung am Batteriestapel in die Nähe des Gegenkontaktabschnitts der entsprechenden Batteriezelle gebracht wird und, bevorzugt automatisch, der Kontaktabschnitt durch das Magnetelement am Gegenkontaktabschnitt fixiert wird. Durch die gleichzeitige zumindest abschnittsweise flexible Ausgestaltung des Kontaktelements kann dies weiter unterstützt werden, da bereits allein durch die magnetische Anziehungskraft zwischen dem Magnetelement und einem Teil des Gegenkontaktabschnitts eine Bewegung des flexiblen Kontaktelements zum Kontaktieren des Kontaktabschnitts am Gegenkontaktabschnitt ausgelöst und bewirkt werden kann. Die Vornahme einer derartigen Fixierung des Kontaktabschnitts des Kontaktelements am Gegenkontaktabschnitt kann auch als ein "Anschnappen" bezeichnet werden. Zusätzliche aufwändige Fixierungen und/oder Befestigungen, insbesondere ein Anlöten des Kontaktabschnitts am Gegenkontaktabschnitt, kann somit vermieden werden. Auf diese Weise kann insbesondere bereitgestellt werden, dass ein Anordnen der Erfassungsvorrichtung am Batteriestapel während der Montage deutlich vereinfacht werden kann, wobei insbesondere Zeit und Kosten eingespart werden können.

Ferner kann bei einer erfindungsgemäßen Erfassungsvorrichtung vorgesehen sein, dass der Sensorabschnitt des Kontaktelements wenigstens ein Sensorelement zum Erfassen zumindest einer der folgenden Batterieeigenschaften der zumindest einen Batteriezelle aufweist:
- Spannung
- Temperatur
- Vibration
- Leckage
- Ladungszustand
- Gesundheitszustand
- Elektrisches Potential

Dabei ist diese Liste nicht abgeschlossen, sodass auch Sensorelemente zum Erfassen weiterer Batterieeigenschaften vorgesehen sein können. Das Sensorelement kann für dieses Erfassen jeweils eine oder mehrere Arten und Weisen einer Messaufnahme verwenden beziehungsweise für diese Messaufnahme geeignet ausgebildet sein, beispielsweise eine analoge, digitale, optische, elektrische, thermische, olfaktorische oder ähnliche Messaufnahme. Für eine Spannung, einen Ladungszustand, einen Gesundheitszustand und/oder ein elektrisches Potential als zu messende Batterieeigenschaft kann beispielsweise das Sensorelement als eine leitende Oberfläche ausgebildet sein. Die Erfassung eines Ladungszustands und/oder eines Gesundheitszustands kann dabei bevorzugt in Kombination mit einer Strommessung erfolgen. Auch eine direkte Erfassung eines Ladungszustands und/oder eines Gesundheitszustands über ein Sensorelement, das für eine optische Erfassung der jeweiligen Batterieeigenschaft ausgebildet ist, ist denkbar. Bereits durch das einfache Kontaktieren des Sensorelements an einer ebenfalls leitenden Oberfläche der Batteriezelle kann eine Spannung der Batteriezelle, bei einer Parallelschaltung aller Batteriezellen einer Batterieebene eine Spannung der gesamten Batterieebene, gemessen werden. Für eine Messung einer Temperatur als Batterieeigenschaft kann das Sensorelement beispielsweise als ein Peltier-Element oder als ein wärmeempfindlicher Widerstand (zum Beispiel pt100) ausgebildet sein. Ein Messen einer Vibration als Batterieeigenschaft kann durch ein Sensorelement, das ein piezo-elektrisches Element aufweist, bereitgestellt werden. Eine Leckage wiederum, die zumeist mit einem Austritt von gasförmigen Substanzen aus der entsprechenden Batteriezelle, die eine Leckage aufweist, einhergeht, kann ein Sensorelement eingesetzt werden, dass einen Gasfühler aufweist.

Besonders bevorzugt kann eine erfindungsgemäße Erfassungsvorrichtung dahingehend ausgebildet sein, dass das Magnetelement auf einer Seite des Kontaktabschnitts angeordnet ist, die im montierten Zustand der Erfassungsvorrichtung von der Batteriezelle abgewandt ist. Auf diese Weise kann bereitgestellt werden, dass der Kontaktabschnitt des Kontaktelements im montierten Zustand der erfindungsgemäßen Erfassungsvorrichtung im Wesentlichen zwischen dem Magnetelement und der zu überwachenden Batteriezelle angeordnet ist. Dies stellt somit ein Einklemmen des Kontaktabschnitts zwischen dem Magnetelement und der Batteriezelle dar. Ein besonders sicheres Anordnen des Kontaktabschnitts im und/oder am Gegenkontaktabschnitt der Batteriezelle kann dadurch bereitgestellt werden. Insbesondere kann dadurch eine Sicherheit beim Anordnen der erfindungsgemäßen Erfassungsvorrichtung am Batteriestapel bereitgestellt werden, da, insbesondere unabhängig von einer Befestigung des Magnetelements am Kontaktabschnitt, bereits durch die Magnetkraft zwischen dem Magnetelement und der Batteriezelle die Positionierung des Kontaktabschnitts am beziehungsweise im Gegenkontaktabschnitt sichergestellt werden kann. Sollte sich die Befestigung des Magnetelements am Kontaktabschnitt im Laufe des Betriebs der Batteriezelle beziehungsweise der erfindungsgemäßen Erfassungsvorrichtung lösen, bleibt durch die Magnetkraft zwischen dem Magnetelement und der Batteriezelle der Kontaktabschnitt dennoch sicher weiterhin im Gegenkontaktabschnitt der Batteriezelle angeordnet.

Auch kann bei einer erfindungsgemäßen Erfassungsvorrichtung vorgesehen sein, dass das Magnetelement stoffschlüssig, insbesondere geschweißt und/oder geklebt, besonders bevorzugt elektrisch leitend geschweißt und/oder geklebt, am Kontaktabschnitt befestigt ist. Auf diese Weise kann ein besonders guter Halt des Magnetelements am Kontaktabschnitt bereitgestellt werden. Insbesondere sind keine zusätzlichen Befestigungsvorrichtungen, wie beispielsweise Schrauben, Schnappelemente oder Ähnliches, nötig, um das Magnetelement am Kontaktabschnitt zu halten. Schweißen und/oder Kleben stellen dabei besonders bevorzugte stoffschlüssige Verbindungen dar. Insbesondere in Ausgestaltungsformen einer erfindungsgemäßen Erfassungsvorrichtung, in der eine Spannung der Batteriezelle überwacht werden soll und in der das Magnetelement im montierten Zustand der Erfassungsvorrichtung die Batteriezelle elektrisch leitend kontaktiert, ist auch ein elektrisch leitendes Schweißen bzw. Kleben bevorzugt, um eine besonders gute Erfassung der Spannung als zu überwachende Batterieeigenschaft bereitstellen zu können.

Besonders bevorzugt kann eine erfindungsgemäße Erfassungsvorrichtung dahingehend ausgebildet sein, dass das Magnetelement eine an eine geometrische Form des Gegenkontaktabschnitts und/oder einer Außenwandung des Batteriestapels angepasste Geometrie aufweist zum zumindest abschnittsweisen formschlüssigen Kontaktieren des Magnetelements und/oder des am Magnetelement anliegenden Bereichs des Kontaktabschnitts mit dem Gegenkontaktabschnitt und/oder der Außenwandung. Auf diese Weise kann eine besonders sichere und positionsgenaue Anordnung des Kontaktabschnitts am bzw. im Gegenkontaktabschnitt sichergestellt werden. Insbesondere durch den Formschluss zwischen dem Kontaktabschnitt bzw. dem Magnetelement und dem Gegenkontaktabschnitt bzw. der Außenwandung kann ein nachträgliches Verrutschen bzw. gegenseitiges Verschieben des Kontaktabschnitts in Bezug auf den Gegenkontaktabschnitt vermieden werden. Beispielsweise kann das Magnetelement eine gebogene Geometrie aufweisen um einem Außenradius einer zylinderförmig ausgebildeten Batteriezelle nachgebildet ausgestaltet zu sein. Insbesondere bei einem Magnetelement, das auf einer der Batteriezelle abgewandten Seite des Kontaktabschnitts angeordnet ist, kann auf diese Weise ein besonders gutes Anliegen eines auf dem Kontaktabschnitt angeordneten Sensorelements, beispielsweise einer leitenden Fläche, auf der gebogenen Oberfläche der Batteriezelle sichergestellt werden. In dieser Ausgestaltungsform bildet sich der Formschluss somit zwischen dem Kontaktabschnitt und dem Gegenkontaktabschnitt. Auch kann beispielsweise eine Erstreckung des Magnetelements entlang einer Höhe der Batterieebene derart ausgebildet sein, dass diese Erstreckung einer lichten Weite des Gegenkontaktabschnitts in dieser Richtung entspricht oder zumindest im Wesentlichen entspricht. So kann beispielsweise der Gegenkontaktabschnitt als ein Spalt zwischen einer Halterung und einer Kühlvorrichtung der Batterieebene bzw. des Batteriestapels ausgebildet sein und das Magnetelement eine derartige Höhe aufweisen, dass es diesen Spalt formschlüssig ausfüllt. Ferner kann der Batteriestapel eine Außenwandung aufweisen, die den gesamten Batteriestapel zumindest teilweise umgibt. Eine Innenwand dieser Außenwandung kann ebenfalls als Basis einer Ausgestaltung einer Geometrie des Magnetelements dienen. Im montierten Zustand bildet sich in diesem Fall ein Formschluss zwischen der Außenwandung und dem Magnetelement aus, sodass das Magnetelement mit anderen Worten durch die Außenwandung in Richtung des Gegenkontaktabschnitts formschlüssig gehalten ist. Auch dadurch kann ein unerwünschtes Entfernen des Magnetelements und damit des gesamten Kontaktelements aus dem Gegenkontaktabschnitt der Batteriezelle sicher vermieden werden.

Ferner kann eine erfindungsgemäße Erfassungsvorrichtung dahingehend ausgebildet sein, dass das Magnetelement zumindest zwei unabhängige und zueinander beabstandete Magnetabschnitte aufweist. Durch das Vorsehen von zwei unabhängigen und zueinander beabstandeten Magnetabschnitten kann insbesondere ein unerwünschtes Ablösen des gesamten Magnetelements von der Batteriezelle und damit ein Lösen der magnetischen Fixierung verhindert werden. Selbst für den Fall, dass sich eines der zumindest zwei unabhängigen Magnetabschnitte von der Batteriezelle löst, bleibt dennoch der zweite Magnetabschnitt magnetisch an der Batteriezelle fixiert. Eine deutliche Steigerung einer Sicherung der magnetischen Fixierung des Kontaktelements bzw. des Kontaktabschnitts im und/oder am Gegenkontaktabschnitt kann dadurch bereitgestellt werden. Diese Sicherung kann auch als eine "Peel-Off"-Sicherung bezeichnet werden.

Darüber hinaus kann bei einer erfindungsgemäßen Erfassungsvorrichtung vorgesehen sein, dass der Kontaktabschnitt zum Kontaktieren von Gegenkontaktabschnitten von zumindest zwei Batteriezellen ausgebildet ist. Dies kann insbesondere dadurch bereitgestellt werden, dass der Kontaktabschnitt bzw. das gesamte Kontaktelement eine größere Erstreckung senkrecht bzw. im Wesentlichen senkrecht zum restlichen Träger aufweist. Auf diese Weise kann das Kontaktelement zwei oder mehrere Batteriezellen übergreifen, wobei die Batteriezellen insbesondere bevorzugt benachbart zueinander in der Batterieebene angeordnet sind. Durch das Kontaktieren von Gegenkontaktabschnitten von mehreren Batteriezellen ist insbesondere auch ein Erfassen von Batterieeigenschaften dieser Batteriezellen ermöglichbar. Eine redundante Messung der zu überwachenden Batterieeigenschaft durch das Erfassen der Batterieeigenschaft an mehreren Batteriezellen kann dadurch ermöglicht werden. Eine höhere Genauigkeit und/oder auch eine gesteigerte Ausfallsicherheit der Überwachung der Batterieeigenschaft kann dadurch bereitgestellt werden.

Bevorzugt kann eine erfindungsgemäße Erfassungsvorrichtung dahingehend weiterentwickelt sein, dass das Magnetelement eine an eine geometrische Form der Gegenkontaktabschnitte der zumindest zwei Batteriezellen angepasste Geometrie aufweist zum zumindest abschnittsweisen formschlüssigen Kontaktieren des Magnetelements und/oder des am Magnetelement anliegenden Bereichs des Kontaktabschnitts mit den Gegenkontaktabschnitten der zumindest zwei Batteriezellen. Auf diese Weise kann auch in dieser Ausgestaltungsform einer erfindungsgemäßen Erfassungsvorrichtung, wie oben bereits für eine Batteriezelle beschrieben, eine besonders sichere und positionsgenaue Anordnung des Kontaktabschnitts auch an bzw. in den Gegenkontaktabschnitten der zumindest zwei Batteriezellen sichergestellt werden. Insbesondere durch den Formschluss zwischen den Kontaktabschnitten und/oder dem Magnetelement und dem Gegenkontaktabschnitt kann ein nachträgliches Verrutschen bzw. gegenseitiges Verschieben des Kontaktabschnitts in Bezug auf die Gegenkontaktabschnitte vermieden werden. Insbesondere beispielsweise bei zylindrisch ausgebildeten Batteriezellen kann das Magnetelement bevorzugt die geometrische Form eines Doppeljochs aufweisen, das jeweils einen konkav gekrümmten Bereich zum Kontaktieren jeder der Batteriezellen aufweist. Eine gleichzeitige magnetische Fixierung mit gleichzeitiger Ausbildung eines Formschlusses zwischen dem Magnetelement und/oder dem Kontaktabschnitt und dem Gegenkontaktabschnitt der jeweiligen Batteriezelle kann dadurch besonders einfach und sicher bereitgestellt werden.

Gemäß einer weiteren bevorzugten Ausgestaltungsform einer erfindungsgemäßen Erfassungsvorrichtung kann ferner vorgesehen sein, dass der Träger zumindest zwei Kontaktelemente zum Kontaktieren von Gegenkontaktabschnitten von zumindest zwei Batteriezellen einer Batterieebene aufweist. Besonders bevorzugt kann dabei vorgesehen sein, dass die zumindest zwei Kontaktelemente auf verschiedenen Seiten des restlichen Trägers bezüglich einer Erstreckung des Trägers entlang einer Höhe einer Batterieebene positioniert sind. Die beiden Kontaktelemente weisen dabei jeweils einen Kontaktabschnitt auf. Auch auf diese Weise ist eine Erfassung von Batterieeigenschaften von zwei oder mehr Batteriezellen einer Batterieebene mit allen oben bereits beschriebenen Vorteilen bezüglich einer Redundanz und/oder Genauigkeit der Messungen bereitstellbar. Insbesondere ist diese Ausgestaltung einer erfindungsgemäßen Erfassungsvorrichtung mit zwei Kontaktelementen auch kombinierbar mit einem Kontaktelement, das sich über mehrere Batteriezellen erstreckt, sodass die Anzahl der überwachbaren Batteriezellen besonders einfach weiter gesteigert werden kann.

Ferner kann bei einer erfindungsgemäßen Erfassungsvorrichtung bevorzugt vorgesehen sein, dass eine Länge des Trägers einer Höhe von zumindest zwei Batterieebenen entspricht und dass zum Kontaktieren eines Gegenkontaktabschnitts zumindest einer Batteriezelle jeder der zumindest zwei Batterieebenen der Träger jeweils zumindest ein Kontaktelement aufweist. Auf diese Weise kann besonders einfach eine Überwachung von Batterieeigenschaften von Batteriezellen zumindest zweier Batterieebenen des Batteriestapels bereitgestellt werden. Besonders bevorzugt weist der Träger eine Länge auf, die einer Gesamthöhe von allen Batterieebenen und dadurch der Höhe des gesamten Batteriestapel entspricht oder zumindest im Wesentlichen entspricht, wobei der Träger für jede der Batterieebenen des Batteriestapels zumindest ein Kontaktelement aufweist. Eine umfassende Überwachung der Batterieeigenschaft von zumindest je einer Batteriezelle aller Batterieebenen des Batteriestapels kann dadurch bereitgestellt werden. Der gesamte Batteriestapel kann auf diese Weise hinsichtlich der zu erfassenden Batterieeigenschaft überwacht werden.

Auch kann eine erfindungsgemäße Erfassungsvorrichtung dahingehend ausgebildet sein, dass der Träger zumindest abschnittsweise flexibel, insbesondere vollständig flexibel, ausgebildet ist. Durch einen derartigen zumindest abschnittsweise flexiblen Träger kann eine Montage einer erfindungsgemäßen Erfassungsvorrichtung an einem Batteriestapel weiter vereinfacht werden. Abschnittsweise flexibel im Sinne der Erfindung kann insbesondere bedeuten, dass ein Ende oder beide Enden bzw. ein mittlerer Abschnitt des Trägers starr ausgebildet, der restliche Träger flexibel ausgebildet ist. Eine Befestigung des Trägers und damit der gesamten Erfassungsvorrichtung am Batteriestapel kann dadurch vereinfacht werden. Auch eine Anordnung von elektrischen Bauelementen auf dem Träger kann in diesen starren Bereichen des Trägers vereinfacht sein. Durch eine teilweise und bevorzugt sogar vollständig flexible Ausgestaltung eines erfindungsgemäßen Trägers kann insbesondere eine Vibrationsfestigkeit einer erfindungsgemäßen Erfassungsvorrichtung weiter gesteigert werden. Vibrationen werden durch die flexible Ausgestaltung des Trägers aufgefangen und insbesondere nicht weitergeleitet. Eine Beeinträchtigung und/oder Beschädigung einer erfindungsgemäßen Erfassungsvorrichtung durch Vibrationen kann dadurch vermieden werden.

Darüber hinaus kann bei einer erfindungsgemäßen Erfassungsvorrichtung vorgesehen sein, dass der Träger zumindest eine Positionierungshilfe zum Zusammenwirken mit zumindest einer Gegenpositionierungshilfe des Batteriestapels aufweist. Als Positionierungshilfen beziehungsweise Gegenpositionierungshilfen im Sinne der Erfindung werden dabei insbesondere geometrische Anordnungen, die bevorzugt formschlüssig ineinandergreifen können, verstanden. Eine Montage einer erfindungsgemäßen Erfassungsvorrichtung kann dadurch vereinfacht werden. Positionierungshilfen im Sinne der Erfindung können dabei beispielsweise Führungsflächen, Schnapp- und Gegenschnappelemente, Stifte und entsprechende Stiftaufnahmen darstellen. Eine relative Positionierung der Erfassungsvorrichtung in Bezug auf den Batteriestapel und somit eine Ausrichtung der erfindungsgemäßen Erfassungsvorrichtung am Batteriestapel während der Montage kann auf diese Weise besonders einfach und insbesondere besonders sicher und genau bereitgestellt werden.

Auch kann eine erfindungsgemäße Erfassungsvorrichtung dahingehend ausgebildet sein, dass auf dem Träger elektronische Bauelemente einer weiteren Vorrichtung, insbesondere einer Batteriesteuerung und/oder einer Kommunikationsschnittstelle, angeordnet sind. Wie oben bereits beschrieben kann sich der Träger einer erfindungsgemäßen

Erfassungsvorrichtung über die gesamte Höhe des Batteriestapels erstrecken. Neben dem Leitungselement, das zum Weiterleiten der durch die Sensorabschnitte ermittelten Daten der zu erfassenden Batterieeigenschaften dient, können bevorzugt auf dem Träger auch weitere elektronische Bauelemente angeordnet sein, um den vorhandenen Bauraum auf dem Träger optimal zu nutzen. So kann bevorzugt beispielsweise zumindest ein Teil einer Batteriesteuerung auch auf dem Träger einer erfindungsgemäßen Erfassungsvorrichtung angeordnet sein. Auch kann der Träger als Anordnungsort für einen Teil einer Kommunikationsschnittstelle, beispielsweise einer Antenne, bevorzugt einer Fraktalantenne, verwendet werden. Eine besonders gute Ausnutzung des vorhandenen Bauraums im Inneren eines Batteriestapels kann dadurch bereitgestellt werden.

Gemäß einem zweiten Aspekt der Erfindung wird die Aufgabe gelöst durch einen Batteriestapel, aufweisend zumindest eine Batterieebene mit wenigstens einer Batteriezelle und eine Erfassungsvorrichtung. Ein erfindungsgemäßer Batteriestapel ist dadurch gekennzeichnet, dass die Erfassungsvorrichtung gemäß dem ersten Aspekt der Erfindung ausgebildet ist. Sämtliche Vorteile, die ausführlich in Bezug auf eine Erfassungsvorrichtung gemäß dem ersten Aspekt der Erfindung beschrieben worden sind, können somit auch durch einen Batteriestapel gemäß dem zweiten Aspekt der Erfindung bereitgestellt werden, der eine derartige Erfassungsvorrichtung gemäß dem ersten Aspekt der Erfindung aufweist.

Gemäß einem dritten Aspekt der Erfindung wird die Aufgabe gelöst durch ein Verfahren zum Montieren einer Erfassungsvorrichtung gemäß dem ersten Aspekt Erfindung an einem Batteriestapel mit zumindest einer Batterieebene mit wenigstens einer Batteriezelle, wobei die wenigstens eine Batteriezelle einen Gegenkontaktabschnitt aufweist. Ein erfindungsgemäßes Verfahren ist durch folgende Schritte gekennzeichnet:
a) Anordnen des Trägers am Batteriestapel,
b) Ausrichten des Trägers zum Annähern des Kontaktabschnitts des zumindest einen Kontaktelements der Erfassungsvorrichtung an den Gegenkontaktabschnitt der wenigstens einen Batteriezelle, und
c) Magnetisches Fixieren des Kontaktabschnitts des zumindest einen Kontaktelements der Erfassungsvorrichtung am Gegenkontaktabschnitt der Batteriezelle durch das Magnetelement.

Ein erfindungsgemäßes Verfahren wird unter Verwendung einer Erfassungsvorrichtung gemäß dem ersten Aspekt Erfindung durchgeführt. Bevorzugt wird ein erfindungsgemäßes Verfahren ferner an einen Batteriestapel gemäß dem zweiten Aspekt der Erfindung durchgeführt. Sämtliche Vorteile, die ausführlich in Bezug auf eine Erfassungsvorrichtung gemäß dem ersten Aspekt der Erfindung und gegebenenfalls in Bezug auf einen Batteriestapel gemäß dem zweiten Aspekt der Erfindung beschrieben worden sind, können somit auch durch ein Verfahren gemäß dem dritten Aspekt der Erfindung bereitgestellt werden.

In einem ersten Schritt a) eines erfindungsgemäßen Verfahrens wird der Träger der Erfassungsvorrichtung am Batteriestapel angeordnet. Ein Anordnen im Sinne der Erfindung kann dabei bereits lediglich ein grobes Annähern des Trägers in die Nähe des Batteriestapels bedeuten. Im nächsten Schritt b) eines erfindungsgemäßen Verfahrens wird eine Ausrichtung des Trägers am Batteriestapel vorgenommen. Für dieses Ausrichten können beispielsweise Positionierungshilfen der Erfassungsvorrichtung und Gegenpositionierungshilfen des Batteriestapels eingesetzt werden. Wesentlich für dieses Ausrichten ist insbesondere, dass ein Annähern des Kontaktabschnitts des zumindest einen Kontaktelements der Erfassungsvorrichtung an den Gegenkontaktabschnitt der wenigsten einen Batteriezelle vorgenommen wird. Ein Annähern im Sinne der Erfindung ist insbesondere eine Verringerung eines Abstands zwischen dem Kontaktabschnitt und dem entsprechenden Gegenkontaktabschnitt. Durch diese Verringerung des Abstands im Schritt b) eines erfindungsgemäßen Verfahrens kann im nächsten Schritt c) durch das Magnetelement das magnetische Fixieren des Kontaktabschnitts des zumindest einen Kontaktelements der Erfassungsvorrichtung am Gegenkontaktabschnitt der Batteriezelle vorgenommen werden. Dies kann manuell, bevorzugt auch automatisch vorgenommen werden. Vorteilhaft bei einem erfindungsgemäßen Verfahren bei Verwendung einer erfindungsgemäßen Erfassungsvorrichtung an einem gesamten Batteriestapel, wobei die Erfassungsvorrichtung für bevorzugt jede der Batterieebenen des Batteriestapel zumindest ein Kontaktelement aufweist, ist dabei, dass das magnetische Fixieren in Schritt c) insbesondere gleichzeitig oder zumindest im Wesentlichen gleichzeitig für alle Kontaktelemente vorgenommen werden kann. Im Wesentlichen gleichzeitig im Sinne der Erfindung kann insbesondere umfassen, dass beispielsweise bereits durch ein insbesondere manuelles Abfahren des Trägers nacheinander ein magnetisches Fixieren sämtlicher Magnetelemente an den jeweiligen Gegenkontaktabschnitten ausgelöst werden kann. Eine besonders einfache Montage einer erfindungsgemäßen Erfassungsvorrichtung an einem Batteriestapel, die insbesondere schnell und dadurch zeit- und kostensparend durchgeführt werden kann, kann auf diese Weise bereitgestellt werden.

Bevorzugt kann bei der Durchführung des Schritts c) eines erfindungsgemäßen Verfahrens, insbesondere beispielsweise beim oben beschriebenen Abfahren des Trägers, das magnetische Feld des zumindest einen Magnetelements durch einen zur Montage der Erfassungsvorrichtung eingesetzten weiteren Magneten, der bevorzugt als Elektromagnet ausgebildet sein kann, kurzzeitig neutralisiert werden. Ein durch das Magnetfeld des Magnetelements verursachtes schnelles Aufsetzen beziehungsweise Anprallen des Kontaktelements, insbesondere des Kontaktabschnitts, im Gegenkontaktabschnitt der Batteriezelle, kann dadurch sicher verhindert werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Die Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen. Elemente mit gleicher Funktion und Wirkungsweise sind in den Figuren mit denselben Bezugszeichen versehen. Es zeigen schematisch:
- Fig. 1: einen erfindungsgemäßen Batteriestapel mit einer erfindungsgemäßen Erfassungsvorrichtung,
- Fig. 2: Schritte a) und c) eines erfindungsgemäßen Verfahrens,
- Fig. 3: eine erste Ausgestaltungsform einer erfindungsgemäßen Erfassungsvorrichtung, und
- Fig. 4: eine zweite Ausgestaltungsform einer erfindungsgemäßen Erfassungsvorrichtung

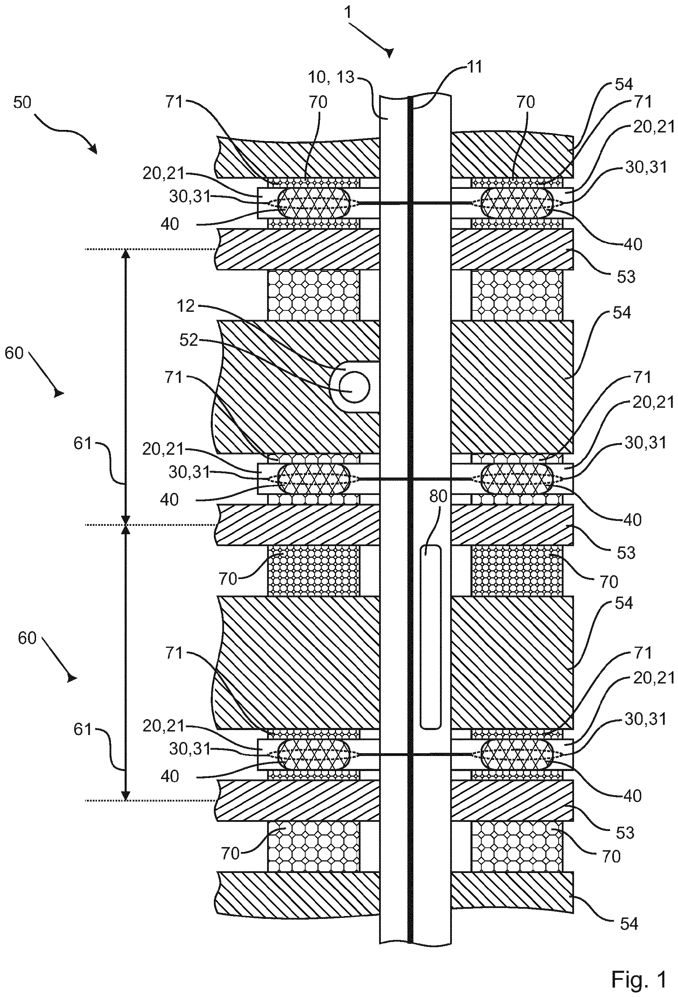

In Fig. 1 ist ein erfindungsgemäßer Batteriestapel 50 gezeigt, der mit einer erfindungsgemäßen Erfassungsvorrichtung 1 ausgerüstet ist. Durch eine erfindungsgemäße Erfassungsvorrichtung 1 kann zumindest eine Batterieeigenschaft der Batteriezellen 70 des Batteriestapels 50 erfasst werden. Dafür weist die Erfassungsvorrichtung 1 einen Träger 10 auf, der wiederum Kontaktelemente 20 und ein Leitungselement 11 aufweist. Die Kontaktelemente 20 umfassen jeweils einen Kontaktabschnitt 21 zum Kontaktieren eines Gegenkontaktabschnitts 71 einer der Batteriezellen 70. Am Kontaktabschnitt 21 ist ferner ein Sensorabschnitt 30 aufweisend ein Sensorelement 31 angeordnet, wobei das Sensorelement 31 auf die zu erfassende Batterieeigenschaft angepasst ausgebildet ist. Das Sensorelement 31 bzw. Sensorabschnitt 30 ist mit dem Leitungselement 11 des Trägers 10 datenkommunizierend verbunden, sodass die durch das Sensorelement 31 erfassten Batterieeigenschaften weitergeleitet, insbesondere an eine nicht mit abgebildete Auswerteeinheit, werden können. Das Sensorelement 31 kann beispielsweise zum Erfassen einer elektrischen Spannung der Batteriezelle 70 als leitende Kontaktfläche ausgebildet sein. Andere, alternative oder zusätzliche Möglichkeiten eines Sensorelements 31 stellen beispielsweise Temperaturfühler zum Messen einer Temperatur der Batteriezelle 70, Vibrationsfühler zum Messen einer Schwingung der Batteriezelle 70 und/oder Gasfühler zum Messen einer Leckage der Batteriezelle 70 dar. Erfindungswesentlich ist das Kontaktelement 20 zumindest abschnittsweise flexibel ausgebildet und weist ferner ein Magnetelement 40 auf. Das Magnetelement 40 ist bevorzugt stoffschlüssig am Kontaktabschnitt 21 befestigt, beispielsweise geklebt oder geschweißt.

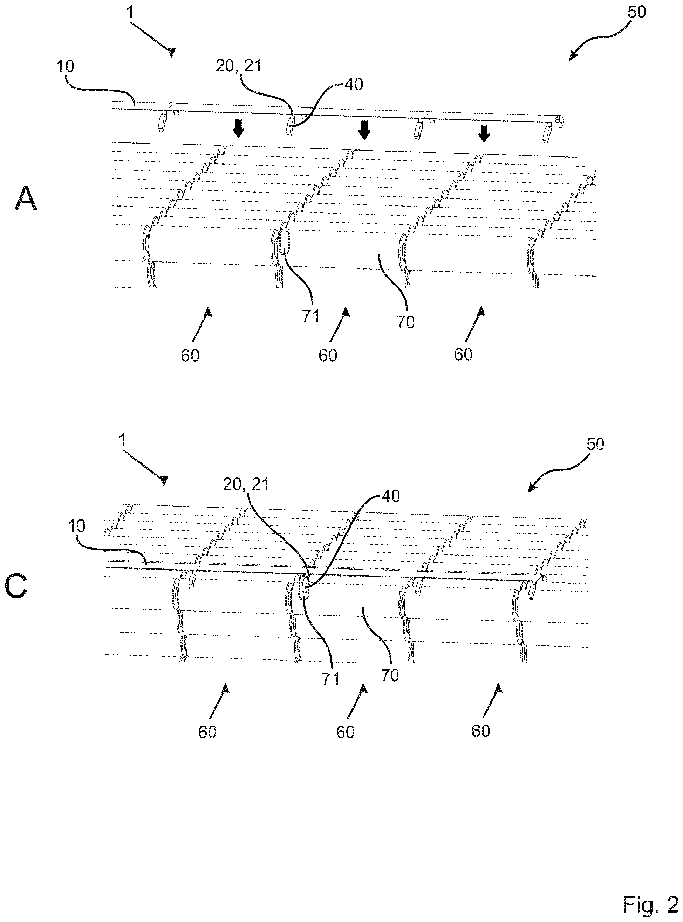

Bei einer Montage der erfindungsgemäßen Erfassungsvorrichtung 1 am Batteriestapel 50 gemäß einem erfindungsgemäßen Verfahren können insbesondere durch die Flexibilität des Kontaktelements 20 und durch das Magnetelement 40 Vorteile erzielt werden. So wird in einem ersten Schritt a) eines erfindungsgemäßen Verfahrens beim Montieren der Erfassungsvorrichtung 1 am Batteriestapel 50 die Erfassungsvorrichtung 1, insbesondere der Träger 10 der Erfassungsvorrichtung 1, ohne exakte Ausrichtung am Batteriestapel 50 angeordnet. Dieser Verfahrensschritt ist schematisch in der oberen Abbildung von Fig. 2 gezeigt und mit A gekennzeichnet, wobei das Anordnen durch entsprechende Pfeile symbolisiert ist. Zur besseren Übersicht ist in Fig. 2 nur eine der vielen Batteriezellen 70 von den mehreren Batterieebenen 60 des Batteriestapels 50 und deren Gegenkontaktabschnitt 71 gekennzeichnet. Ferner ist der Batteriestapel 50 ohne eine Halterung 53 und eine Kühlvorrichtung 54 abgebildet. Der Träger 10 der in Fig. 2 abgebildeten Erfassungsvorrichtung 1 weist mehrere Kontaktelemente 20 mit Kontaktabschnitten 21 und Magnetelementen 40 auf, von denen ebenfalls jeweils nur ein Exemplar mit Bezugszeichen versehen ist.

In einem nächsten Schritt b) erfolgt eine Ausrichtung des Trägers 10 am Batteriestapel 50. Für diesen Zweck kann der Träger 10, wie in Fig. 1 gezeigt, insbesondere eine Positionierungshilfe 12 aufweisen, die mit einer Gegenpositionierungshilfe 52 des Batteriestapels 50 zusammenwirken kann. Wie abgebildet können dabei die Positionierungshilfe 12 beispielsweise als eine Stiftaufnahme und die Gegenpositionierungshilfe 52 als ein entsprechender Stift am Batteriestapel 50 ausgebildet sein. Eine exakte Anordnung und Ausrichtung des Trägers 10 und dadurch der gesamten Erfassungsvorrichtung 1 kann auf diese Weise bereitgestellt werden. Insbesondere wird durch diese Ausrichtung sichergestellt, dass der Kontaktabschnitt 21 des Kontaktelements 20 an einen entsprechenden Gegenkontaktabschnitt 71 einer Batteriezelle 70 angenähert wird.

Dies ermöglicht im nächsten Schritt c) eines erfindungsgemäßen Verfahrens, dargestellt in der unteren Abbildung der Fig. 2 und mit C gekennzeichnet, dass durch das Magnetelement 40 des Kontaktelements 20 eine bevorzugt zumindest im Wesentlichen automatische magnetische Fixierung des Kontaktabschnitts 21 im und/oder am Gegenkontaktabschnitt 71 erfolgt. Das Magnetelement 40 übt auf zumindest einen Bereich des Gegenkontaktabschnitts 71 eine magnetische Kraft aus und wird somit in Richtung des Gegenkontaktabschnitts 71 gezogen. Durch die zumindest abschnittsweise flexible Ausgestaltung des Kontaktelements 20 kann das Kontaktelement 20 der Bewegung des Magnetelement 40 folgen und wird somit ebenfalls magnetisch im und/oder am Gegenkontaktabschnitt 71 fixiert. Aufwändige alternative Befestigungsarten, wie beispielsweise ein Anlöten der Kontaktabschnitte 21 an den Gegenkontaktabschnitten 71, können dadurch vermieden werden. Eine Montage einer erfindungsgemäßen Erfassungsvorrichtung 1 an einen Batteriestapel 50 kann dadurch deutlich vereinfacht und beschleunigt werden.

Wie in Fig. 1 und Fig. 2 gezeigt, kann der Batteriestapel 50 mehrere Batterieebenen 60 aufweisen, in denen wiederum mehrere Batteriezellen 70 zusammengefasst sind. Bevorzugt sind die Batteriezellen 70 einer Batterieebene 60 elektrisch parallel geschaltet. Der Träger 10 der erfindungsgemäßen Erfassungsvorrichtung 1 erstreckt sich bevorzugt über eine Höhe 61 mehrerer Batterieebenen 60, besonders bevorzugt über alle Batterieebenen 60 des Batteriestapels 50. Auch kann der Träger 10 mindestens abschnittsweise ebenfalls flexibel ausgebildet sein, beispielsweise um eine Weiterleitung von Vibrationen entlang des Batteriestapels 50 zu verhindern. Ferner kann der auf dem Träger 10 vorhandene Bauraum für elektronische Bauelemente 80 einer weiteren Vorrichtung genutzt werden, beispielsweise einer Batteriesteuerung und/oder einer Kommunikationsschnittstelle. Der Träger 10 weist ferner für jede der Batterieebenen 60 zumindest ein Kontaktelement 20 auf. Dieses Kontaktelement 20 kann sich, wie abgebildet, zumindest im Wesentlichen senkrecht zur Längserstreckung des restlichen Trägers 10 erstrecken. Ein Kontaktabschnitt 21 des Kontaktelements 20 ist insbesondere für ein Kontaktieren eines Gegenkontaktabschnitts 71 der jeweiligen Batteriezelle 70 ausgebildet. Der Gegenkontaktabschnitt 71 kann dabei beispielsweise von der Batteriezelle 70 selbst oder, wie abgebildet, von der Batteriezelle 70, einer Halterung 53 und einer Kühlvorrichtung 54 der jeweiligen Batterieebene 60 gebildet sein. Auch kann, wie gemäß der abgebildeten bevorzugten Ausgestaltungsform einer erfindungsgemäßen Erfassungsvorrichtung 1 gezeigt, der Träger 10 für jede der Batterieebenen 60 zwei Kontaktelemente 20 aufweisen, die sich auf verschiedenen Seiten des restlichen Abschnitts des Trägers 10 erstrecken und so eine Kontaktierung von zumindest zwei Batteriezellen 70 jeder Batterieebene 60 ermöglichen. Eine redundante Messung der zu erfassenden Batterieeigenschaft an mehreren Batteriezellen 70 einer Batterieebene 60 kann dadurch besonders einfach bereitgestellt werden.

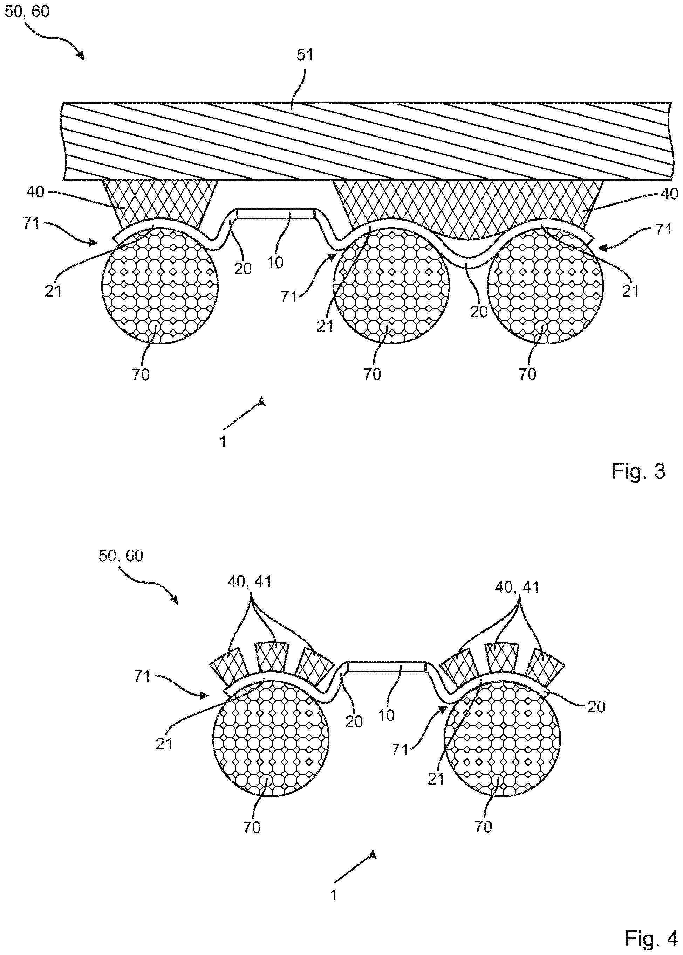

Die Fig. 3 zeigt eine erste mögliche Ausgestaltungsform einer erfindungsgemäßen Erfassungsvorrichtung 1. Gezeigt ist insbesondere eine Schnittdarstellung senkrecht zu einer Höhe 61 (nicht mit abgebildet) einer Batterieebene 60, wobei die Schnittebene durch die Gegenkontaktabschnitte 71 der gezeigten Batteriezellen 70 gelegt ist. In der dargestellten Ausgestaltungsform weist die Erfassungsvorrichtung 1 neben dem Träger 10 zwei Kontaktelemente 20 auf, wobei sich eines der beiden Kontaktelemente 20 über eine Batteriezelle 70, das zweite über zwei Batteriezellen 70 erstreckt. Die jeweiligen Sensorabschnitte 30 der Kontaktabschnitte 21, die den einzelnen Batteriezellen 70 zugeordnet sind, sind nicht mit abgebildet. Deutlich sichtbar ist, dass die Kontaktelemente 20 zumindest teilweise flexibel ausgebildet sind. Dadurch ist ein Kontaktieren der Batteriezellen 70 besonders einfach möglich. Ferner sind für beide Kontaktelemente 20 die jeweiligen Magnetelement 40 mit abgebildet. Die Magnetelemente 40 sind dabei jeweils an einer der Batteriezellen 70 abgewandten Seite des Kontaktabschnitts 21 angeordnet. Selbst wenn sich die Befestigung des Magnetelement 40 am Kontaktabschnitt 21, die beispielsweise durch einen Stoffschluss bereitgestellt wird, lösen würde, bleibt durch die magnetische Fixierung des Magnetelements 40 an der Batteriezelle 70 auch der Kontaktabschnitt 21 automatisch im Gegenkontaktabschnitt 71 der Batteriezelle 70 fixiert und angeordnet. Dabei ist auf der linken Seite eine Geometrie des Magnetelement 40 zum einen an eine geometrische Form der Batteriezelle 70 und zum anderen an eine geometrische Form einer Außenwandung 51 des Batteriestapel 50 angepasst ausgebildet. Dadurch kann ein formschlüssiges Anliegen des Magnetelements 40 an der Außenwandung 51 und des am Magnetelement 40 angeordneten Bereichs des Kontaktabschnitts 21 an der Batteriezelle 70 besonders einfach bereitgestellt werden. Insbesondere durch den Formschluss zwischen der Außenwandung 51 und dem Magnetelement 40 kann im fertig montierten Batteriestapel 50 die Anordnung der Kontaktabschnitte 21 der erfindungsgemäßen Erfassungsvorrichtung 1 in den Gegenkontaktabschnitten 71 der Batteriezellen 70 zusätzlich zu magnetischen Fixierung durch das Magnetelement 40 weiter unterstützt werden. Auf der rechten Seite erstreckt sich, wie oben bereits ausgeführt, das Kontaktelement 20 bzw. der Kontaktabschnitt 21 des Kontaktelements 20 über zwei benachbarte Batteriezellen 70. Wie dargestellt kann bevorzugt das Magnetelement 40 an die geometrische Form der beiden Batteriezellen 70 angepasst ausgebildet sein, insbesondere beispielsweise in der geometrischen Form eines Doppeljochs. Auf diese Weise kann durch ein einziges Magnetelement 40 eine magnetische Fixierung der Kontaktabschnitte 21 des Kontaktelements 20 an den Gegenkontaktabschnitten 71 beider Batteriezellen 70 besonders einfach bereitgestellt werden.

In Fig. 4 wird eine erfindungsgemäße Erfassungsvorrichtung 1 gezeigt, die in der abgebildeten Ausgestaltungsform ebenfalls neben dem Träger 10 zwei Kontaktelemente 20 mit Kontaktabschnitten 21 zum Kontaktieren von Gegenkontaktabschnitten 71 zweier Batteriezellen 70 der Batterieebene 60 aufweist. Auch hier ist eine Schnittdarstellung senkrecht zu einer Höhe 61 (nicht mit abgebildet) einer Batterieebene 60 des Batteriestapels 50 gezeigt. Im Unterschied zur in Fig. 3 gezeigten Ausgestaltungsform weisen hier die Magnetelemente 40 jeweils mehrere, insbesondere drei, Magnetabschnitte 41 auf, die unabhängig und voneinander beabstandet sind. Auf diese Weise kann insbesondere eine Sicherheit gegen ein Ablösen des Magnetelements 40 von der jeweiligen Batteriezelle 70, das zu einem Verlust der magnetischen Fixierung des Kontaktelements 20 führen würde, erhöht werden. Selbst wenn sich einer der Magnetabschnitte 41 lösen würde, bleiben die anderen Magnetabschnitte 41 des jeweiligen Magnetelements 40 sicher magnetisch fixiert an der entsprechenden Batteriezelle 70. Durch die Anordnung des Magnetelements 40 beziehungsweise der Magnetabschnitte 41 an einer der Batteriezelle 70 abgewandten Seite des Kontaktelements 20, bleibt dadurch auch das Kontaktelement 20 sicher am und/oder im Gegenkontaktabschnitt 71 der Batteriezelle 70 magnetisch fixiert. Ein Erfassen der gewünschten Batterieeigenschaft durch den Sensorabschnitt 30 (nicht mit abgebildet) kann auf diese Weise zu jeder Zeit sichergestellt werden.

### Bezugszeichen

- 1: Erfassungsvorrichtung

- 10: Träger
- 11: Leitungselement
- 12: Positionierungshilfe
- 13: Länge

- 20: Kontaktelement
- 21: Kontaktabschnitt

- 30: Sensorabschnitt
- 31: Sensorelement

- 40: Magnetelement
- 41: Magnetabschnitt

- 50: Batteriestapel
- 51: Außenwandung
- 52: Gegenpositionierungshilfe
- 53: Halterung
- 54: Kühlvorrichtung

- 60: Batterieebene
- 61: Höhe

- 70: Batteriezelle
- 71: Gegenkontaktabschnitt

- 80: Bauelement

## Patentansprüche

1. Batteriestapel (50), aufweisend zumindest eine Batterieebene (60) mit wenigstens einer Batteriezelle (70) und einer Erfassungsvorrichtung (1), wobei die Erfassungsvorrichtung (1) zum Erfassen wenigstens einer Batterieeigenschaft der zumindest einen Batteriezelle (70) der zumindest einen Batterieebene (60) des Batteriestapels (50), die Erfassungsvorrichtung (1) aufweisend einen Träger (10) mit zumindest einem elektrischen Leitungselement (11) und mindestens einem Kontaktelement (20) mit einem Kontaktabschnitt (21) zum Kontaktieren eines Gegenkontaktabschnitts (71) der zumindest einen Batteriezelle (70), wobei das Kontaktelement (20) einen Sensorabschnitt (30) zum Erfassen der wenigstens einen Batterieeigenschaft der Batteriezelle (70) aufweist und der Sensorabschnitt (30) mit dem zumindest einen Leitungselement (11) zum Weiterleiten der zumindest einen erfassten Batterieeigenschaft datenkommunizierend verbunden ist, **dadurch gekennzeichnet, dass** das Kontaktelement (20) zumindest abschnittsweise flexibel ausgebildet ist und ein Magnetelement (40) zum magnetischen Fixieren des Kontaktabschnitts (21) am Gegenkontaktabschnitt (71) aufweist.

2. Batteriestapel (50) nach Anspruch 1, **dadurch gekennzeichnet, dass** der Sensorabschnitt (30) des Kontaktelements (20) wenigstens ein Sensorelement (31) zum Erfassen zumindest einer der folgenden Batterieeigenschaften der zumindest einen Batteriezelle (70) aufweist:
- Spannung
- Temperatur
- Vibration
- Leckage
- Ladungszustand
- Gesundheitszustand
- Elektrisches Potential

3. Batteriestapel (50) nach Anspruch 1 oder 2, **dadurch gekennzeichnet, dass** das Magnetelement (40) auf einer Seite des Kontaktabschnitts (21) angeordnet ist, die im montierten Zustand der Erfassungsvorrichtung (1) von der Batteriezelle (70) abgewandt ist.

4. Batteriestapel (50) nach einem der vorangegangenen Ansprüche, **dadurch gekennzeichnet, dass** das Magnetelement (40) stoffschlüssig, insbesondere geschweißt und/oder geklebt, besonders bevorzugt elektrisch leitend geschweißt und/oder geklebt, am Kontaktabschnitt (21) befestigt ist.

5. Batteriestapel (50) nach einem der vorangegangenen Ansprüche, **dadurch gekennzeichnet, dass** das Magnetelement (40) eine an eine geometrische Form des Gegenkontaktabschnitts (71) und/oder einer Außenwandung (51) des Batteriestapels (50) angepasste Geometrie aufweist zum zumindest abschnittsweisen formschlüssigen Kontaktieren des Magnetelements (40) und/oder des am Magnetelement (40) anliegenden Bereichs des Kontaktabschnitts (21) mit dem Gegenkontaktabschnitt (71) und/oder der Außenwandung (51).

6. Batteriestapel (50) nach einem der vorangegangenen Ansprüche, **dadurch gekennzeichnet, dass** das Magnetelement (40) zumindest zwei unabhängige und zueinander beabstandete Magnetabschnitte (41) aufweist.

7. Batteriestapel (50) nach einem der vorangegangenen Ansprüche, **dadurch gekennzeichnet, dass** der Kontaktabschnitt (21) zum Kontaktieren von Gegenkontaktabschnitten (71) von zumindest zwei Batteriezellen (70) ausgebildet ist.

8. Batteriestapel (50) nach Anspruch 7, **dadurch gekennzeichnet, dass** das Magnetelement (40) eine an eine geometrische Form der Gegenkontaktabschnitte (71) der zumindest zwei Batteriezellen (70) angepasste Geometrie aufweist zum zumindest abschnittsweisen formschlüssigen Kontaktieren des Magnetelements (40) und/oder des am Magnetelement (40) anliegenden Bereichs des Kontaktabschnitts (21) mit den Gegenkontaktabschnitten (71) der zumindest zwei Batteriezellen (70).

9. Batteriestapel (50) nach einem der vorangegangenen Ansprüche, **dadurch gekennzeichnet, dass** der Träger (10) zumindest zwei Kontaktelemente (20) zum Kontaktieren von Gegenkontaktabschnitten (71) von zumindest zwei Batteriezellen (70) einer Batterieebene (60) aufweist.

10. Batteriestapel (50) nach einem der vorangegangenen Ansprüche, **dadurch gekennzeichnet, dass** eine Länge (13) des Trägers (10) einer Höhe (61) von zumindest zwei Batterieebenen (60) entspricht und dass zum Kontaktieren eines Gegenkontaktabschnitts (71) zumindest einer Batteriezelle (70) jeder der zumindest zwei Batterieebenen (60) der Träger (10) jeweils zumindest ein Kontaktelement (20) aufweist.

11. Batteriestapel (50) nach einem der vorangegangenen Ansprüche, **dadurch gekennzeichnet, dass** der Träger (10) zumindest abschnittsweise flexibel, insbesondere vollständig flexibel, ausgebildet ist.

12. Batteriestapel (50) nach einem der vorangegangenen Ansprüche, **dadurch gekennzeichnet, dass** der Träger (10) zumindest eine Positionierungshilfe (12) zum Zusammenwirken mit zumindest einer Gegenpositionierungshilfe (52) des Batteriestapels (50) aufweist.

13. Batteriestapel (50) nach einem der vorangegangenen Ansprüche, **dadurch gekennzeichnet, dass** auf dem Träger (10) elektronische Bauelemente (80) einer weiteren Vorrichtung der Erfassungsvorrichtung (1), insbesondere einer Batteriesteuerung und/oder einer Kommunikationsschnittstelle, angeordnet sind.

14. Verfahren zum Montieren einer Erfassungsvorrichtung (1) an einem Batteriestapel (50) gemäß einem der Ansprüche 1 bis 13 mit zumindest einer Batterieebene (60) mit wenigstens einer Batteriezelle (70), wobei die wenigstens eine Batteriezelle (70) einen Gegenkontaktabschnitt (71) aufweist, **gekennzeichnet durch folgende Schritte:**
a) Anordnen des Trägers (10) am Batteriestapel (50),
b) Ausrichten des Trägers (10) zum Annähern des Kontaktabschnitts (21) des zumindest einen Kontaktelements (20) der Erfassungsvorrichtung (1) an den Gegenkontaktabschnitt (71) der wenigstens einen Batteriezelle (70), und
c) Magnetisches Fixieren des Kontaktabschnitts (21) des zumindest einen Kontaktelements (20) der Erfassungsvorrichtung (1) am Gegenkontaktabschnitt (71) der Batteriezelle (70) durch das Magnetelement (40).

## Claims

1. Battery stack (50), having at least one battery level (60) with at least one battery cell (70) and a detection device (1), the detection device (1) being configured for detecting at least one battery characteristic of the at least one battery cell (70) of the at least one battery level (60) of the battery stack (50), the detection device (1) having a carrier (10) with at least one electrical line element (11) and at least one contact element (20) with a contact section (21) for contacting a mating contact section (71) of the at least one battery cell (70), the contact element (20) having a sensor section (30) for detecting the at least one battery characteristic of the battery cell (70) and the sensor section (30) being connected in a data-communicating manner to the at least one line element (11) for forwarding the at least one detected battery characteristic, **characterized in that** the contact element (20) is designed to be flexible at least in sections and has a magnetic element (40) for magnetically fixing the contact section (21) to the mating contact section (71).

2. Battery stack (50) according to claim 1,
**characterized in that**
the sensor section (30) of the contact element (20) comprises at least one sensor element (31) for detecting at least one of the following battery characteristics of the at least one battery cell (70):
- Tension
- Temperature
- Vibration
- Leakage
- State of charge
- State of health
- Electrical potential

3. Battery stack (50) according to claim 1 or 2,
**characterized in that**
the magnetic element (40) is arranged on a side of the contact section (21) which faces away from the battery cell (70) in the mounted state of the detection device (1).

4. Battery stack (50) according to one of the preceding claims,
**characterized in that**
the magnetic element (40) is attached to the contact section (21) in a materially bonded, in particular welded and/or glued, particularly preferably electrically conductively welded and/or glued.

5. Battery stack (50) according to one of the preceding claims,
**characterized in that**
the magnetic element (40) has a geometry adapted to a geometric shape of the mating contact section (71) and/or an outer wall (51) of the battery stack (50) for at least section-wise positive contacting of the magnetic element (40) and/or the region of the contact section (21) bearing against the magnetic element (40) with the mating contact section (71) and/or the outer wall (51).

6. Battery stack (50) according to one of the preceding claims,
**characterized in that**
the magnetic element (40) comprises at least two independent and spaced-apart magnetic sections (41).

7. Battery stack (50) according to one of the preceding claims,
**characterized in that**
the contact section (21) is designed for contacting mating contact sections (71) of at least two battery cells (70).

8. Battery stack (50) according to claim 7,
**characterized in that**
the magnetic element (40) has a geometry adapted to a geometric shape of the mating contact sections (71) of the at least two battery cells (70) for at least section-wise positive contacting of the magnetic element (40) and/or of the region of the contact section (21) bearing against the magnetic element (40) with the mating contact sections (71) of the at least two battery cells (70).

9. Battery stack (50) according to one of the preceding claims,
**characterized in that**
the carrier (10) has at least two contact elements (20) for contacting mating contact sections (71) of at least two battery cells (70) of a battery level (60).

10. Battery stack (50) according to one of the preceding claims,
**characterized in that**
a length (13) of the carrier (10) corresponds to a height (61) of at least two battery levels (60), and **in that** for contacting a mating contact section (71) of at least one battery cell (70) of each of the at least two battery levels (60), the carrier (10) has at least one contact element (20) in each case.

11. Battery stack (50) according to one of the preceding claims,
**characterized in that**
the carrier (10) is designed to be flexible, in particular completely flexible, at least in sections.

12. Battery stack (50) according to one of the preceding claims,
**characterized in that**
the carrier (10) comprises at least one positioning aid (12) for cooperating with at least one counter-positioning aid (52) of the battery stack (50).

13. Battery stack (50) according to one of the preceding claims,
**characterized in that**
electronic components (80) of a further device of the detection device (1), in particular a battery controller and/or a communication interface, are arranged on the carrier (10).

14. A method for mounting a detection device (1) on a battery stack (50) according to any one of claims 1 to 13, comprising at least one battery level (60) with at least one battery cell (70), wherein the at least one battery cell (70) comprises a mating contact section (71),
**characterized by the following steps:**
a) Arrange the carrier (10) on the battery stack (50),
b) Alignment of the carrier (10) for approaching the contact section (21) of the at least one contact element (20) of the detection device (1) to the mating contact section (71) of the at least one battery cell (70), and
c) Magnetic fixing of the contact section (21) of the at least one contact element (20) of the detection device (1) to the mating contact section (71) of the battery cell (70) by the magnetic element (40).

## Revendications

1. Pile de batteries (50), présentant au moins un plan de batterie (60) avec au moins une cellule de batterie (70) et un dispositif de détection (1), le dispositif de détection (1) servant à détecter au moins une caractéristique de batterie de la au moins une cellule de batterie (70) du au moins un plan de batterie (60) de la pile de batteries (50), le dispositif de détection (1) présente un support (10) avec au moins un élément conducteur électrique (11) et au moins un élément de contact (20) avec une section de contact (21) pour entrer en contact avec une section de contact complémentaire (71) de l'au moins une cellule de batterie (70), l'élément de contact (20) présentant une section de capteur (30) pour détecter l'au moins une caractéristique de batterie de la cellule de batterie (70) et la section de capteur (30) étant reliée de manière à communiquer des données avec l'au moins un élément conducteur (11) pour transmettre l'au moins une caractéristique de batterie détectée,
**caractérisé en ce que**
l'élément de contact (20) est flexible au moins par sections et présente un élément magnétique (40) pour fixer magnétiquement la section de contact (21) sur la section de contact complémentaire (71).

2. Pile de batteries (50) selon la revendication 1,
**caractérisé en ce que** la section de capteur (30) de l'élément de contact (20) comprend au moins un élément de détection (31) pour détecter au moins l'une des caractéristiques de batterie suivantes de l'au moins une cellule de batterie (70) :
- Tension
- Température
- Vibration
- Fuite
- État de la charge
- État de santé
- Potentiel électrique

3. Pile de batteries (50) selon la revendication 1 ou 2,
**caractérisé en ce que**
l'élément magnétique (40) est disposé sur un côté de la section de contact (21) qui est opposé à la cellule de batterie (70) lorsque le dispositif de détection (1) est monté.

4. Pile de batteries (50) selon l'une des revendications précédentes,
**caractérisé en ce que**
l'élément magnétique (40) est fixé à la section de contact (21) par liaison de matière, en particulier par soudage et/ou collage, de préférence par soudage et/ou collage électroconducteur.

5. Pile de batteries (50) selon l'une des revendications précédentes,
**caractérisé en ce que**
l'élément magnétique (40) présente une géométrie adaptée à une forme géométrique de la section de contact complémentaire (71) et/ou d'une paroi extérieure (51) de la pile de batteries (50) pour mettre en contact, au moins par sections et par complémentarité de forme, l'élément magnétique (40) et/ou la zone de la section de contact (21) adjacente à l'élément magnétique (40) avec la section de contact complémentaire (71) et/ou la paroi extérieure (51).

6. Pile de batteries (50) selon l'une des revendications précédentes,
**caractérisé en ce que**
l'élément magnétique (40) comprend au moins deux sections magnétiques (41) indépendantes et espacées l'une de l'autre.

7. Pile de batteries (50) selon l'une des revendications précédentes,
**caractérisé en ce que**
la section de contact (21) est conçue pour entrer en contact avec des sections de contact complémentaires (71) d'au moins deux cellules de batterie (70).

8. Pile de batteries (50) selon la revendication 7,
**caractérisé en ce que**
l'élément magnétique (40) présente une géométrie adaptée à une forme géométrique des sections de contact complémentaires (71) des au moins deux cellules de batterie (70) pour la mise en contact par complémentarité de forme au moins par sections de l'élément magnétique (40) et/ou de la zone de la section de contact (21) adjacente à l'élément magnétique (40) avec les sections de contact complémentaires (71) des au moins deux cellules de batterie (70).

9. Pile de batteries (50) selon l'une des revendications précédentes,
**caractérisé en ce que**
le support (10) comprend au moins deux éléments de contact (20) pour mettre en contact des sections de contact complémentaire (71) d'au moins deux cellules de batterie (70) d'un plan de batterie (60).

10. Pile de batteries (50) selon l'une des revendications précédentes,
**caractérisé en ce qu'une**
longueur (13) du support (10) correspond à une hauteur (61) d'au moins deux plans de batterie (60) et **en ce que**, pour mettre en contact une section de contact complémentaire (71) d'au moins une cellule de batterie (70) de chacun des au moins deux plans de batterie (60), la support (10) présente respectivement au moins un élément de contact (20).

11. Pile de batteries (50) selon l'une des revendications précédentes,
**caractérisé en ce que**
le support (10) est flexible au moins par sections, en particulier entièrement flexible.

12. Pile de batteries (50) selon l'une des revendications précédentes,
**caractérisé en ce que**
le support (10) comprend au moins un auxiliaire de positionnement (12) destiné à coopérer avec au moins un auxiliaire de contre-positionnement (52) de la pile de batteries (50).

13. Pile de batteries (50) selon l'une des revendications précédentes,
**caractérisé en ce que**
des composants électroniques (80) d'un autre dispositif du dispositif de détection (1), notamment d'une commande de batterie et/ou d'une interface de communication, sont disposés sur le support (10).

14. Procédé de montage d'un dispositif de détection (1) sur une pile de batteries (50) selon l'une quelconque des revendications 1 à 13, comportant au moins un plan de batterie (60) avec au moins une cellule de batterie (70), ledit au moins une cellule de batterie (70) comportant une section de contact complémentaire (71),
**caractérisé par les étapes suivantes:**
a) Disposer le support (10) sur la pile de batteries (50),
b) Orienter le support (10) pour rapprocher la section de contact (21) de l'au moins un élément de contact (20) du dispositif de détection (1) de la section de contact complementaire (71) de l'au moins une cellule de batterie (70), et
c) Fixation magnétique de la section de contact (21) de l'au moins un élément de contact (20) du dispositif de détection (1) sur la section de contact complémentaire (71) de la cellule de batterie (70) par l'élément magnétique (40).
